# EUROPÄISCHE PATENTSCHRIFT

(11) **EP 1 199 758 B1**
(45) Veröffentlichungstag und Bekanntmachung des Hinweises auf die Patenterteilung: **12.04.2006**
(21) Anmeldenummer: 01120532.5
(22) Anmeldetag: 29.08.2001
(51) Int. Cl.: H01L 41/047, H01L 41/053, H01L 41/24

(54) **Elektromechanisches Funktionsmodul**
Electromechanical function module
Module fonctionnel électromécanique

(30) Priorität: 19.10.2000 DE 10051784
(43) Veröffentlichungstag der Anmeldung: 24.04.2002
(73) Patentinhaber: DLR Deutsches Zentrum für Luft- und Raumfahrt e.V., 51147 Köln (DE)
(72) Erfinder: Wierach, Peter, 38667 Bad Harzburg (DE)
(74) Vertreter: Gerstein, Hans Joachim

(56) Entgegenhaltungen:
- WO-A-97/18450
- US-A- 4 849 668
- US-A- 5 319 153
- US-A- 5 656 882
- US-A- 5 920 145
- US-B1- 6 191 519

## Beschreibung

Die Erfindung betrifft ein elektromechanisches Funktionsmodul mit mindestens einem Wandler, mit mehreren Faser-Zwischenlagen mit Ausschnitten zur Aufnahme der Wandler, und mit Faser-Decklagen auf der oberen und unteren Faser-Zwischenlage, wobei die Faser-Zwischenlagen und Faser-Decklagen aus nichtleitendem Fasermaterial bestehen und zusammenlaminiert sind.

Derartige Funktionsmodule werden z.B. in Form von piezoelektrischen Wandlerelementen vor allem für Struktursysteme verwendet, die sich mit selbstregelnden Mechanismen an veränderte Umgebungsbedingungen anpassen können und als adaptive Strukturen bzw. Smart Structures bezeichnet werden. Bei derartigen adaptiven Strukturen sind Sensoren und Aktuatoren in Verbindung mit geeigneten Reglern in die Struktur integriert. Damit ist eine solche Struktur in der Lage, äußere Veränderungen zu detektieren und darauf entsprechend zu reagieren. Die adaptiven Komponenten sind im Unterschied zu konventionellen Strukturen mit passiven Feder- oder Dämpferelementen ein integraler Bestandteil der Struktur. Auftretende Störungen, wie z. B. ungewollte Verformungen oder Schwingungen, können direkt am Ort der Entstehung bekämpft werden.

Da die Strukturen tragende und aktuatorische bzw. sensorische Funktionen in sich vereinen, bieten sie für den Leichtbau und den damit verbundenen Anwendungen in der Luft- und Raumfahrttechnik ein großes Potential. Daneben ergeben sich aber auch für andere Industriezweige vielseitige Anwendungsmöglichkeiten z. B. zur Lärm- und Schwingungsreduktion, zur Konturverformung und Stabilisierung (Shape-Control) und zur Feinstpositionierung.

Als Aktuatoren und Sensoren, die in die Struktur integriert werden, können vorteilhaft piezokeramische Werkstoffe unter Ausnutzung des piezoelektrischen bzw. des inversen piezoelektrischen Effekts genutzt werden. Allerdings sind sie aufgrund ihrer Beschaffenheit extrem spröde und brechen deshalb sehr leicht. Dieser Nachteil macht sich insbesondere beim Einsatz von dünnen, scheibenförmigen Piezokeramiken bzw. Piezofolien mit einer Dicke von ca. 0,2 mm deutlich bemerkbar. Vor dem Einbau einer Piezofolie wird diese daher herkömmlicherweise umhüllt und damit mit definierten mechanischen und elektrischen Randbedingungen versehen. Hierdurch wird die Handhabung der Piezofolien erheblich vereinfacht. In solche elektromechanische Funktionsmodule sind eine elektrische Kontaktierung der Elektroden des piezokeramischen Wandlers und elektrische Anschlüsse für den Wandler in das Funktionsmodul eingebettet.

Derartige elektronische Funktionsmodule können als Dehnungs- und Biegeaktuatoren bzw. -sensoren in beliebige Strukturen integriert bzw. auf diese appliziert werden. Sie können zudem als komplexe Geometrien hergestellt werden.

Die Verwendung von piezoelektrischen Wandlern sowohl als Aktuator als auch als Sensor ist z. B. aus der US-PS 5,347,870 bekannt.

In der US-PS 4,849,668 ist die direkte Integration von Piezokeramiken in mehrschichtige Strukturen, wie z. B. Kohlenfaserlaminat, beschrieben. Innere Schichten der Strukturen haben Ausschnitte zur Aufnahme der Piezokeramiken. Zwischen den Piezokeramiken sind Isolierschichten vorgesehen. Nachteilig müssen die piezoelektrischen Aktuatoren bzw. Sensoren während der Herstellung der Struktur kontaktiert und gefertigt werden. Zudem ergeben sich mechanische Probleme, insbesondere bei der Dauerfestigkeit der elektrischen Kontakte, der elektrischen Isolierung der stromführenden Komponenten und durch die Bruchgefahr der spröden Piezokeramik bei der Herstellung.

Aus der US-PS 5,485,053 ist eine dreischichtige schwingungs- und schalldämpfende Struktur bekannt, bei der eine viskoelastische Dämpfungsschicht zwischen zwei piezoelektrischen Schichten angeordnet ist. Eine piezoelektrische Schicht dient als Schwingungssensor, während die andere piezoelektrische Schicht als Aktuator zur Kompensation der Schwingungen verwendet wird.

In der US-PS 5, 378, 974 ist die Verwendung von gegenläufig betriebenen piezokeramischen Aktuatoren für ein Schwingungsdämpfungssystem bekannt. Ein entsprechendes System ist auch in der US-PS 5,315,203 beschrieben, wobei das elektrische Feld eines piezoelektrischen Elementes entgegengesetzt auf ein zweites piezoelektrisches Element aufgebracht. Auf diese Weise wird eine gegenläufige Verformung bewirkt, ohne das weitere Regelmechanismen erforderlich sind.

Weiterhin sind piezoelektrische Funktionsmodule bekannt, die als vorgefertigte Kompaktelemente in Verbundstrukturen eingebaut werden können.

So ist aus der US-PS 4,876,776 der Einbau von piezoelektrischen Elementen in eine Verbundstruktur bekannt, wobei die Verbundstruktur Aussparungen zur Aufnahme der piezoelektrischen Elemente hat und vor dem Einbau der piezoelektrischen Elemente vorgefertigt ist.

Aus der US-PS 5,305,507 ist der Einbau eines piezoelektrischen Aktuators oder Sensors in ein nicht leitendes Faserverbundmaterial, wie z. B. Glasfaser oder Epoxid beschrieben. Hierbei werden die piezokeramischen Elemente zunächst verdrahtet und erst dann einlaminiert.

Aus den US-PS 5,687,462 und 5,657,882 sowie der WO 95/20827 ist ein piezoelektrisches Funktionsmodul bekannt, bei dem eine Piezokeramik vorzugsweise in eine Polyimidfolie verklebt ist. Die Elektroden werden über dünne aufgelegte Leiterbahnen aus Kupferfolie kontaktiert, die ebenfalls zwischen den Polyimidfolien verklebt werden. Der elektrische Anschluss der piezoelektrischen Wandler erfolgt über Stecker, die an die Polyimidfolien angeklemmt werden.

Aus der WO 95/20827, Seite 9, Zeilen 26 ff. ist weiterhin die Verwendung von Rahmenelementen zwischen den Polyimidfolien zur Aufnahme der Piezokeramiken bekannt, die auch als Abstandshalter bei der Fertigung dienen. Die Rahmenelemente sind aus einem relativ stark komprimierbaren Material, wie z. B. aus einem nicht quer verbundenen Polymer hergestellt und haben ein geringes Elastizitätsmodul.

Bei den bekannten piezoelektrischen Funktionsmodulen ist insbesondere die Kontaktierung problematisch. Bei langen Betriebszeiten ist in den aus dünner Kupferfolie gebildeten Leiterbahnen am Übergang zwischen dem piezoelektrischen Wandler und der umgebenen Hülle eine Rissbildung zu beobachten. Aufgrund der Kontaktierung aus einer Kupferfolie ist die Elektrode der Piezokeramik auch nur unvollständig abgedeckt, so dass bei einem Bruch in der Piezokeramik ein Verlust der aktiven Leistungsfähigkeit auftritt.

Bei der Integration der herkömmlichen piezoelektrischen Funktionsmodule in Faserverbundstrukturen müssen weiterhin nachteilig relativ viele Fasern zur Durchführung des elektrischen Anschlusses nach außen durchtrennt werden. Dies beeinträchtigt die Festigkeit der Faserverbundstruktur unmittelbar.

Zudem ist die Adhäsion der Polyimidfolie in Faserverbundstrukturen relativ schlecht, so dass die Oberflächen aufwändig bearbeitet werden müssen. Polyimidfolien nehmen auch relativ viel Feuchtigkeit auf, so dass die Gefahr von elektrischen Durchschlägen bei einem Betrieb des piezoelektrischen Funktionsmodule in feuchter Umgebung besteht.

Aufgabe der Erfindung war es daher, ein verbessertes piezoelektrisches Funktionsmodul zu schaffen.

Die Aufgabe wird durch das piezoelektrische Funktionsmodul mit den Merkmalen des Patentanspruchs 1 dadurch gelöst, dass gewebte elastische elektrische Kontaktbahnen mit den Faser-Decklagen zur Kontaktierung der Wandler integral verbunden sind, wobei die Kontaktbahnen für einen Wandler die Elektroden des zugehörigen Wandlers nahezu vollständig abdecken.

Durch die Verwendung von Faser-Deckmaterial ergibt sich eine gute Verbindung des Funktionsmoduls mit der Verbundstruktur in die das Funktionsmodul eingebaut wird. Die gewebten elastischen elektrischen Kontaktbahnen, die mit der Faser-Decklage integral verbunden sind, gewährleisten einen dauerhaften zuverlässigen Kontakt mit dem Wandler, z.B. einer Piezokeramik. Die elektrischen Kontaktbahnen werden durch die Faser-Decklage nach außen geführt. Ein Durchtrennen der Fasern und eine Störung der Faserverbundstruktur mit der Folge eines Festigkeitsverlustes tritt hierdurch nicht auf.

Durch die Verwendung von mehreren Faser-Zwischenlagen, die mit den Faser-Decklagen zusammenlaminiert werden, wird eine integrale Struktur gebildet, in die der Wandler vollständig eingekapselt ist. Durch Auswahl des Fasermaterials, des Harzsystems und durch die Orientierung der Fasern kann die Steifigkeit des Funktionsmoduls im Hinblick auf die Dehnungsübertragung zwischen dem elektromechanischen Funktionsmodul und der diese umgebende Verbundstruktur beeinflusst werden.

Die Kontaktbahnen sind vorzugsweise in die Faser-Decklagen eingelegte gewebte Kohlenstofffaser oder Metalldrähte. Durch eine derartige elastische Kontaktierung der Elektroden der Wandler werden die Dauerfestigkeitseigenschaften verbessert. Die Wandler können z.B. piezokeramisch oder elektrostriktiv arbeiten.

Die Faser-Decklagen und Faser-Zwischenlagen sind vorzugsweise aus Polyestervlies gebildet.

Zur rationellen und störunanfälligen Herstellung der vorbeschriebenen elektromechanischen Funktionsmodule werden folgende Schritte vorgeschlagen:
a) Auflaminieren der Kontaktbahnen auf die Faser-Decklagen mit einem Epoxidharz mit thermoplastischen Eigenschaften;
b) Zusammenlegen der Bauelemente des Funktionsmoduls;
c) Injektion einer Harzmatrix in das Funktionsmodul.

Die Injektion folgt vorzugsweise unter Vakuum, z.B. nach dem Differential-Pressure-Resin-Transfer-Moulding-Verfahren. Dies hat den Vorteil, dass ein hoher Faservolumengehalt ohne Lufteinschlüsse erzielt werden kann.

Die Erfindung wird nachfolgend anhand der beigefügten Zeichnungen näher erläutert. Es zeigen:
- Figur 1 -: perspektivische Ansicht eines erfindungsgemäßen elektromechanischen Funktionsmoduls;
- Figur 2 -: perspektivische Explosionsdarstellung einer Gruppe von elektromechanischen Funktionsmodulen;
- Figur 3 -: perspektivische Explosionsdarstellung eines herkömmlichen piezoelektrischen Funktionsmodulen;
- Figur 4 -: Draufsicht auf elektromechanische Funktionsmodule mit verschiedenen elektrischen Anschlussmöglichkeiten;
- Figur 5 -: perspektivische Ansicht von komplexen Bauformen erfindungsgemäßer elektromechanischer Funktionsmodule.

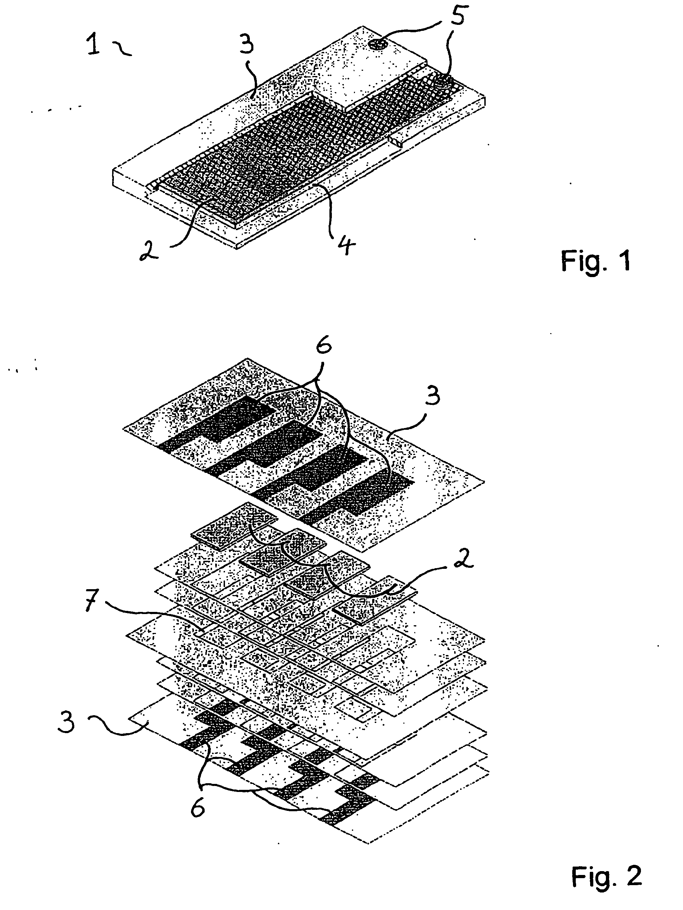

Die Figur 1 lässt ein piezoelektrisches elektromechanisches Funktionsmodul 1 in perspektivischer Ansicht erkennen. Das piezoelektrische Funktionsmodul 1 als Wandler hat eine bekannte Piezokeramik 2 oder Piezofolie, die mit einer elektrisch isolierenden Hülle umgeben ist. Diese Hülle wird aus nicht leitenden Faser-Decklagen 3 auf der Ober- und Unterseite der Piezokeramik 2 sowie aus mehreren nicht leitenden Faser-Zwischenlagen 4 gebildet. Die elektrischen Anschlüsse für die Elektroden der Piezokeramik 2 sind aus den Faser-Decklagen 3 in Form von Kontaktpunkten 5 herausgeführt.

Die Figur 2 lässt den Aufbau einer Gruppe von piezoelektrischen Funktionsmodulen 1 im Detail als Explosionsdarstellung erkennen. In die Faser-Decklagen 3 sind gewebte elastische elektrische Kontaktbahnen 6, z. B. in Form von Kohlenstofffasergeweben oder dünnen Metalldrahtgeweben vorgesehen. Die elektrischen Kontaktbahnen 6 sind als Gewebe integral mit den Faser-Decklagen 3 verbunden und decken die Fläche der Piezokeramik 2 nahezu vollständig ab. Sie werden z.B. mit einem Epoxidharz mit thermoplastischen Eigenschaften auf die Faser-Decklagen 3 laminiert. Durch das großflächige Kontaktieren der Elektroden der Piezokeramik 2 auf beiden Seiten wird die Schadenstoleranz im Falle von Bruchstellen in der Piezokeramik verringert. Es wird auch dann gewährleistet, dass die Elektrodenfläche nahezu vollständig elektrisch kontaktiert bleibt. Durch die Verwendung von Gewebe als Kontaktbahnen 6 wird gewährleistet, dass das Funktionsmodul elastisch bleibt und eine höhere Lebensdauer hat.

Zwischen den Faser-Decklagen 3 sind mehrere Faser-Zwischenlagen 4 vorgesehen, die Ausschnitte 7 zur Aufnahme der Piezokeramiken 2, d. h, der piezoelektrischen Wandler haben. Durch Anpassung der Lagenanzahl der Faser-Zwischenlagen 4 können unterschiedlich dicke Funktionsmodule 1 hergestellt und der Druck auf die spröde bruchgefährdete Piezokeramik 2 während des Kompressionsvorganges bei der Herstellung eingestellt werden. Die Faser-Zwischenlagen 4 dienen somit als Abstandshalter für die Piezokeramik 2. Mit Hilfe der Ausschnitte 7 in den Faser-Zwischenlagen 4 werden die Piezokeramiken 2 während der Herstellung in ihrer Position gehalten, so dass sie sich nicht mehr verschieben können.

Die Faser-Decklagen 3 und Faser-Zwischenlagen 4 werden durch geeignete Verfahren, wie z. B. das Differential-Pressure-Resin-Transfer-Moulding (DP-RTM)-Injektionsverfahren unter Vakuum zusammenlaminiert. Die mechanische Druckvorspannung der piezoelektrischen Funktionsmodule 1 kann durch geeignete Auswahl der Harzsysteme und Härtezyklen für das Laminat eingestellt werden. Dabei sind die unterschiedlichen thermischen Ausdehnungskoeffizienten der Faser-Zwischenlagen 4 und Faser-Decklagen 3 sowie der Piezokeramiken 2 zu berücksichtigen. Durch die Auswahl des Harzsystems können aber auch die elastischen Eigenschaften der Hülle des Funktionsmoduls 1 und damit Dehnungsübertragung zwischen dem Funktionsmoduls 1 und einer äußeren Verbundstruktur beeinflusst werden.

Die Figur 2 lässt ein Layout mit vier Funktionsmodulen 1 erkennen. Aus der dargestellten Faserverbundplatte können die gewünschten Einheiten mit ein oder mehreren Funktionsmodulen 1 ausgeschnitten werden. Die gruppenweise Fertigung der Funktionsmodule ist sehr rationell und fertigungstechnisch vorteilhaft.

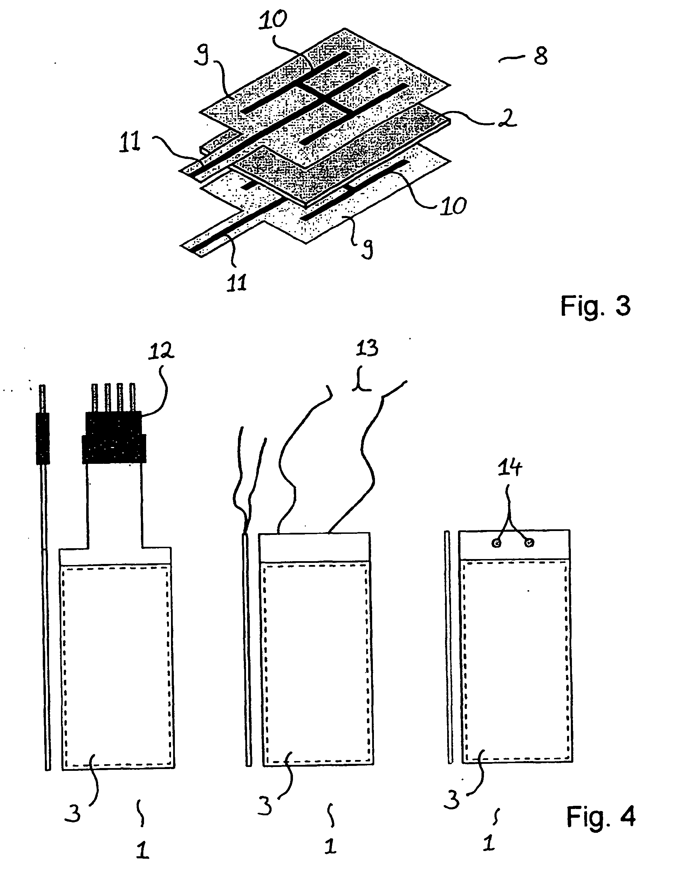

Die Figur 3 lässt ein herkömmliches piezoelektrisches Funktionsmodul 8 in Explosionsdarstellung erkennen. Hierbei ist die Piezokeramik 2 in eine Hülle aus oberer und unterer Trägerfolie 9 eingeklebt. Auf der Innenseite der Trägerfolie 9 sind Leiterbahnen 10 zur elektrischen Kontaktierung der Piezokeramik 2 aufgeklebt. Die Trägerfolien 9 haben jeweils eine Anschlussfahne 11 zum Anschluss externer elektrischer Schaltungen, die aus der Faserverbundstruktur herausgeführt wird, in die das piezoelektrische Funktionsmodul 8 eingebaut ist. Der elektrische Anschluss der Leiterbahnen 10 erfolgt vorzugsweise über Stecker. Als Trägerfolie 9 werden Polyimidfolien verwendet, die eine relative hohe Feuchtigkeitsaufnahmekapazität haben. Hierdurch besteht die Gefahr elektrischer Durchschläge bei einem Betrieb des Funktionsmoduls 8 in feuchter Umgebung. Zudem ist eine ungenügende Adhäsion der Polyimidfolie in Faserverbundstrukturen zu beobachten, so dass die Oberflächen der Faserverbundstrukturen aufwändig bearbeitet werden müssen. Durch den relativ breiten elektrischen Anschluss des Funktionsmoduls 8 müssen relativ viele Fasern bei der Integration der Funktionsmoduls 8 in Faserverbundstrukturen durchtrennt werden, um den elektrischen Anschluss nach außen zu führen. Dies führt zu einen Festigkeitsverlust. Zudem ist bei langen Betriebszeiten in den Leiterbahnen 10 an der relativ dünnen Kupferfolie am Übergang zwischen der Piezokeramik 2 und der Trägerfolie 9 eine Rissbildung zu beobachten.

Im Unterschied zu diesem herkömmlichen Funktionsmodul 8 sind, wie in der Figur 1 und 2 gezeigt, erfindungsgemäß Faser-Zwischenlagen 4 vorgesehen, mit denen gewebte elastische elektrische Kontaktbahnen 6, integral verbunden sind. Die Faser-Zwischenlagen 4 dienen hierbei als Abstandshalter zur optimalen Einkapselung der Piezokeramiken 2. Dadurch, dass durchgängig Fasermaterial verwendet wird, können die Faser-Decklagen 3 und die Faser-Zwischenlagen 4 zusammenlaminiert werden, wobei die mechanischen Parameter der so entstandenen Hülle einstellbar ist.

Die Funktionsmodule 1 werden mit den in der Figur 4 beispielhaft skizzierten elektrischen Anschlüssen an externe Schaltungen angeschlossen. Die elektrischen Kontaktbahnen 6 können hierbei über eine Anschlussfahne mit einem Stecker 12 aus dem Faserverbundsystem herausgeführt werden. Es können aber auch einzelne Leitungen 13 aus dem Funktionsmodul 1 herausgeführt sein. Besonders vorteilhaft ist die Verwendung von Lötpunkten 14 in den Faser-Decklagen 3. Diese Anschlussvariante ermöglicht das nachträgliche Stapeln und Anordnen mehrerer Funktionsmodule 1 zu Modulpaketen. Hierbei werden die Funktionsmodule 1 so angeordnet, dass die Lötpunkte 14 mit Kontakt zueinander übereinander liegen. Es könnten Biegewandler realisiert werden, indem die Funktionsmodule so übereinander gelegt werden, dass ihre Lötpunkte 14 jeweils mit entgegengesetzter Polarität verbunden werden.

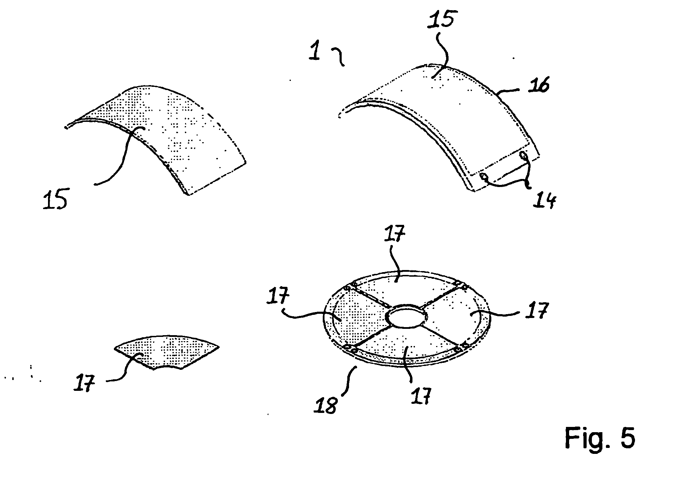

Die Figur 5 lässt Funktionsmodule 1 in Form von komplexen Gebilden erkennen. Es kann z. B. eine gekrümmte Piezofolie 15 in eine entsprechend gekrümmte Hülle 16 eingebaut werden. Zudem können die Piezofolien auch als Kreissegmente 17 in ein tellerförmiges Gebilde 18 eingebaut werden, wobei z. B. jedes vierte Kreissegment separat ansteuerbar ist. Weitere komplexe Formen beliebiger Art sind entsprechend denkbar.

## Patentansprüche

1. Elektromechanisches Funktionsmodul (1) mit mindestens einem Wandler, mit mehreren Faser-Zwischenlagen (4) mit Ausschnitten (7) zur Aufnahme der Wandler, und mit Faser-Decklagen (3) auf der oberen und unteren Faser-Zwischenlage (4), wobei die Faser-Zwischenlagen (4) und Faser-Decklagen (3) aus nichtleitendem Fasermaterial bestehen und zusammenlaminiert sind, **dadurch gekennzeichnet, dass** gewebte elastische elektrische Kontaktbahnen (6) mit den Faser-Decklagen (3) zur Kontaktierung der Wandler integral verbunden sind, wobei die Kontaktbahnen (6) für einen Wandler die Elektroden des zugehörigen Wandlers nahezu vollständig abdecken.

2. Elektromechanisches Funktionsmodul (1) nach Anspruch 1, **dadurch gekennzeichnet, dass** die Kontaktbahnen (6) gewebte Kohlenstofffasern sind.

3. Elektromechanisches Funktionsmodul (1) nach Anspruch 1, **dadurch gekennzeichnet, dass** die Kontaktbahnen (6) gewebte Metalldrähte sind.

4. Elektromechanisches Funktionsmodul (1) nach einem der vorhergehenden Ansprüche, **dadurch gekennzeichnet, dass** die Faser-Zwischenlagen (4) und die Faser-Decklagen (3) mit einem Harzsystem zusammenlaminiert sind und einen elektrischen Faserverbund bilden.

5. Elektromechanisches Funktionsmodul (1) nach einem der vorhergehenden Ansprüche, **dadurch gekennzeichnet, dass** die Wandler piezokeramisch sind.

6. Elektromechanisches Funktionsmodul (1) nach einem der vorhergehenden Ansprüche, **dadurch gekennzeichnet, dass** die Wandler elektrostriktiv sind.

7. Elektromechanisches Funktionsmodul (1) nach einem der vorhergehenden Ansprüche, **dadurch gekennzeichnet, dass** die Faser-Decklagen (3) und Faser-Zwischenlagen (4) aus Polyestervlies gebildet sind.

8. Verfahren zur Herstellung eines elektromechanischen Funktionsmoduls (1) nach einem der Ansprüche 1 bis 7, **gekennzeichnet durch** die Schritte:
a) Auflaminieren der Kontaktbahnen (6) auf die Faser-Decklagen (3) mit einem Epoxidharz mit thermoplastischen Eigenschaften;
b) Zusammenlegen der Bauteile des Funktionsmoduls (1);
c) Injektion einer Harzmatrix in das Funktionsmodul (1).

9. Verfahren nach Anspruch 8, **dadurch gekennzeichnet, dass** die Injektion im Schritt c) unter Vakuum erfolgt.

## Revendications

1. Module fonctionnel électromagnétique (1) comprenant au moins un convertisseur, plusieurs couches intercalaires en fibres (4), des découpes (7) pour recevoir le convertisseur et des couches de couverture en fibres (3) sur la couche intercalaire en fibres (4) supérieure et inférieure, dans lequel, les couches intercalaires en fibres (4) et les couches de couverture en fibres (3) sont en matière fibreuse non conductrice et sont laminées ensemble, **caractérisé en ce que** des pistes de contact (6) tissées et élastiques sont liées d'une seule pièce avec les couches de couverture en fibres (3) pour contacter le convertisseur, les pistes de contact (6) d'un convertisseur recouvrant sensiblement complètement les électrodes du convertisseur associé.

2. Module fonctionnel électromagnétique (1) selon la revendication 1 **caractérisé en ce que** les pistes de contact (6) sont des fibres de carbone tissées.

3. Module fonctionnel électromagnétique (1) selon la revendication 1, **caractérisé en ce que** les pistes de contact (6) sont des fils métalliques tissés.

4. Module fonctionnel électromagnétique (1) selon l'une des revendications précédentes, **caractérisé en ce que** les couches intercalaires en fibres (4) et les couches de couverture en fibres (3) sont laminées ensemble avec un système de résine et forment un composite électrique à base de fibres.

5. Module fonctionnel électromagnétique (1) selon l'une des revendications précédentes, **caractérisé en ce que** les convertisseurs sont piézocéramiques.

6. Module fonctionnel électromagnétique (1) selon l'une des revendications précédentes, **caractérisé en ce que** les convertisseurs sont électrostrictifs.

7. Module fonctionnel électromagnétique (1) selon l'une des revendications précédentes, **caractérisé en ce que** les couches intercalaires en fibres (4) et les couches de couverture en fibres (3) sont sous forme de nappe de polyester.

8. Procédé pour la fabrication d'un module fonctionnel électromagnétique (1) selon l'une des revendications 1 à 7, **caractérisé par** les étapes de :
a) surlaminage des pistes de contact (6) sur les couches de couverture en fibres (3) au moyen d'une résine époxy ayant des propriétés thermoplastiques ;
b) assembler les composants du module fonctionnel (1) ;
c) injecter une matrice de résine dans le module fonctionnel (1).

9. Procédé selon la revendication 8, **caractérisé en ce que** l'injection de l'étape c) a lieu sous vide.

## Claims

1. Electromechanical function module (1) with at least one converter, having a number of intermediate fibre layers (4) with cutouts (7) for receiving the converters, and having covering fibre layers (3) on the upper and lower intermediate fibre layers (4), the intermediate fibre layers (4) and the covering fibre layers (3) consisting of nonconducting fibrous material and being laminated together, **characterized in that** woven elastic electrical contact paths (6) are integrally connected to the covering fibre layers (3) for the contacting of the converters, the contact paths (6) for a converter covering the electrodes of the associated converter virtually completely.

2. Electromechanical function module (1) according to Claim 1, **characterized in that** the contact paths (6) are woven carbon fibres.

3. Electromechanical function module (1) according to Claim 1, **characterized in that** the contact paths (6) are woven metal wires.

4. Electromechanical function module (1) according to one of the preceding claims, **characterized in that** the intermediate fibre layers (4) and the covering fibre layers (3) are laminated together with a resin system and form an electrical fibre composite.

5. Electromechanical function module (1) according to one of the preceding claims, **characterized in that** the converters are piezoceramic.

6. Electromechanical function module (1) according to one of the preceding claims, **characterized in that** the converters are electrostrictive.

7. Electromechanical function module (1) according to one of the preceding claims, **characterized in that** the covering fibre layers (3) and intermediate fibre layers (4) are formed from polyester nonwoven.

8. Method for producing an electromechanical function module (1) according to one of Claims 1 to 7, **characterized by** the steps of:
(a) laminating the contact paths (6) onto the covering fibre layers (3) with an epoxy resin having thermoplastic properties;
(b) assembling the components of the function module (1) ;
(c) injecting a resin matrix into the function module (1).

9. Method according to Claim 8, **characterized in that** the injection in step c) takes place under a vacuum.
